# EUROPÄISCHE PATENTSCHRIFT

(11) **EP 2 529 070 B1**
(45) Veröffentlichungstag und Bekanntmachung des Hinweises auf die Patenterteilung: **11.05.2016**
(21) Anmeldenummer: 11700737.7
(22) Anmeldetag: 13.01.2011
(51) Int. Cl.: E05D 3/02, E05D 1/06, E05D 11/10

(54) **KÜHLGERÄT, INSBESONDERE FÜR EINEN SCHALTSCHRANK**
COOLING DEVICE, IN PARTICULAR FOR A SWITCH CABINET
APPAREIL DE RÉFRIGÉRATION, NOTAMMENT POUR UN ARMOIRE DE DISTRIBUTION

(30) Priorität: 26.01.2010 DE 102010000198
(43) Veröffentlichungstag der Anmeldung: 05.12.2012
(73) Patentinhaber: Rittal GmbH & Co. KG, 35745 Herborn (DE)
(72) Erfinder: IMMEL, Manfred, 35756 Mittenaar (DE); MAUL, Joachim, 35630 Ehringshausen (DE)
(74) Vertreter: Angerhausen, Christoph
(86) Internationale Anmeldenummer: PCT/EP2011/050378
(87) Internationale Veröffentlichungsnummer: WO 2011/092058

(56) Entgegenhaltungen:
- EP-A1- 1 947 547
- EP-A2- 1 548 217
- WO-A1-2010/095999
- GB-A- 2 022 663
- GB-A- 2 047 311
- GB-A- 2 130 638
- US-A- 2 619 021
- US-A1- 2001 052 168

## Beschreibung

Die Erfindung betrifft ein Kühlgerät, insbesondere für einen Schaltschrank, mit einem Gehäuse, das eine Öffnung aufweist, in die oder in deren Bereich eine Ventilatorbaugruppe mit einem Träger und einem Ventilator einsetzbar ist, wobei der Träger mit dem Gehäuse lösbar verbunden ist.

Derartige Ventilatorbaugruppen sind in verschiedensten Ausführungen z. B. auch für den Haushaltsbereich, erhältlich. Ein Beispiel ist der US 2,619,021 angegeben. Dabei wird üblicherweise der Ventilator an dem Träger angeschraubt und die so entstandene Baueinheit in einen Durchbruch des Kühlgerät-Gehäuses eingesetzt. Die Verbindung zwischen der Ventilatorbaugruppe und dem Kühlgerät-Gehäuse erfolgt über Schraubverbindungen. Im Wartungsfall kann es vorkommen, dass der Ventilator inspiziert oder ausgetauscht werden muss. Zu diesem Zweck wird die Ventilatorbaugruppe von dem Gehäuse losgeschraubt und abgenommen. Anschließend muss die Steckverbindung, über die der Ventilator vom Kühlgerät aus mit elektrischer Energie versorgt wird, getrennt werden. Gegebenenfalls sind noch zusätzliche Steuerleitungen zu trennen. Anschließend kann die Ventilatorbaugruppe entfernt werden. Dieses Vorgehen erweist sich insbesondere dann als mühsam, wenn die Platzverhältnisse beengt sind oder sehr schwere Ventilatoren verbaut sind. Bei dem beschriebenen Ventilator ist daher vorgesehen, diesen aus seiner Montageposition verschwenken zu können

Ein Kühlgerät mit den Merkmalen des Oberbegriffs von Anspruch 1 ist aus der EP 1 947 547 A1 bekannt. In der Montageposition des Trägers lagert eine Anschlagleiste des Trägers gegen einen gehäuseseitigen Anschlag.

Es ist Aufgabe der Erfindung, ein Kühlgerät der eben erwähnten Art bereitzustellen, bei dem die Montage bzw. Demontage der Ventilatorbaugruppe montagefreundlich durchführbar ist.

Diese Aufgabe wird durch ein Kühlgerät nach Anspruch 1 gelöst. Vorteilhafte Ausgestaltungen sind Gegenstand der Unteransprüche.

In der Montageposition kann der Träger mit dem Ventilator sicher an dem Kühlgerät festgelegt werden. Soll nun der Ventilator zu Wartungszwecken zugänglich gemacht werden, so kann er über die Scharnierverbindung in die Parkstellung geschwenkt werden, in der der Scharnierbolzen in eine Schwenkaufnahme in Form einer seitlichen Ausbuchtung der Scharnieraufnahme hinein verstellt und darin formschlüssig gehalten ist, wobei eine Abdeckung des Trägers auf eine untere horizontale Abkantung des Gehäuses trifft. In dieser Parkstellung kann der Monteur die elektrische Steckverbindung zum Kühlgerät einfach lösen. Anschließend kann er die Ventilatorbaugruppe dann vom Kühlgerät abheben und ggf. einen neue Ventilatorbaugruppe einbauen, wobei diese dann wieder zunächst in die Parkstellung gehangen wird. Anschließend wird dann die elektrische Kabelverbindung hergestellt, die Ventilatorbaugruppe in die Montageposition geschwenkt und am Gehäuse festgelegt.

Erfindungsgemäß ist vorgesehen, dass der Scharnierbolzen in einer langlochartigen Scharnieraufnahme verstellbar ist, wobei die Scharnieraufnahme einen Einführabschnitt aufweist, durch den der Scharnierbolzen aus der oder in die Scharnieraufnahme bewegbar ist. Diese Gestaltung ermöglicht eine einfache und zielgerichtete Montage bzw. Demontage der Ventilatorbaugruppe.

Weiter ist der Scharnierbolzen in der Montagestellung des Trägers in einer Parkaufnahme der Scharnieraufnahme gehalten, und der Scharnierbolzen ist in der abgeklappten Stellung des Trägers in eine Schwenkaufnahme hinein verstellbar und darin formschlüssig gehalten. Über diese formschlüssige Verbindung wird eine zuverlässige Sicherung der Ventilatorbaugruppe erreicht.

Eine eindeutige Demontage bzw. Montage der Ventilatorbaugruppe lässt sich auch dadurch erreichen, dass die Scharnieraufnahme eine Schiebeführung aufweist, in der der Scharnierbolzen zwischen der der Montageposition zugeordneten Stellung und einer Demontagestellung verstellbar ist.

Die Scharnierverbindung lässt sich dadurch auf einfachste Weise herstellen, dass das Gehäuse eine Wandung aufweist, die von zwei einander gegenüberliegenden Rändern begrenzt ist, dass die Ränder von der Wandung abgekantet sind und rückseitig über diese vorstehen, und dass die Ränder jeweils eine Scharnieraufnahme oder einen Scharnierbolzen aufweisen.

Der Teileaufwand der Ventilatorbaugruppe lässt sich dann reduzieren, wenn vorgesehen ist, dass der Träger ein einteilig angeformtes Lüftungsgitter aufweist. Der Träger kann dabei insbesondere als Kunststoff-Spritzgussteil ausgebildet sein.

Denkbar ist es auch, dass der Träger einen Luftdurchtrittsquerschnitt aufweist, der von einem einteilig an dem Träger angeformten Düsenansatz begrenzt ist. Über den Düsenansatz kann dem Ventilator Luft strömungsgünstig zugeleitet werden. Um den Ventilator an dem Träger mit geringem Teileaufwand befestigen zu können, ist eine bevorzugte Erfindungsausgestaltung derart, dass der Träger rückseitig vorstehende Schraubdome aufweist, mit denen eine Trägerplatte verbunden ist, und dass die Trägerplatte den Ventilator auswechselbar aufnimmt.

Ein erfindungsgemäßes Kühlgerät kann auch dadurch gekennzeichnet sein, dass der Träger eine Abdeckung aufweist, die die Öffnung des Gehäuses zumindest bereichsweise überdeckt, dass an die Abdeckung mittelbar oder unmittelbar Seitenteile angeformt sind, die rückseitig über die Abdeckung vorstehen und im montierten Zustand des Trägers durch die Öffnung hindurchreichen, und dass die Seitenteile die Scharnierbolzen oder die Scharnieraufnahmen tragen.

Eine platzsparende Bauweise, bei der die Ventilatorbaugruppe wenig über die Vorderseite des Gehäuses aufträgt, kann dann erreicht werden, wenn vorgesehen ist, dass die Schwenkachse der Schwenklagerung im Bereich der Rückseite der Abdeckung des Trägers verläuft. Insbesondere kann die Schwenkachse dabei am unteren horizontalen Rand der Ventilatorbaugruppe horizontal verlaufen.

Eine sichere Befestigung des Kühlgerätes gelingt auf einfache Weise dadurch, dass der Träger an gegenüberliegenden Seiten an dem Gehäuse verschraubbar ist, wobei er sich an einer Seite vorderseitig an einer Wandung des Gehäuses und an der anderen Seite rückseitig an dieser abstützt. Auf diese Weise kann die Ventilatorbaugruppe an der Wandung des Gehäuses verspannt werden.

Die Erfindung wird im Folgenden anhand eines in den Zeichnungen dargestellten Ausführungsbeispieles näher erläutert. Es zeigen:
- Figur 1: in perspektivischer Frontansicht ein Teil eines Gehäuses eines Kühlgerätes mit einer in Montagestellung befindlichen Ventilatorbaugruppe;
- Figur 2: die Anordnung gemäß Figur 1 in Seitenansicht und im Vertikalschnitt mit abgeklappter und in Parkstellung verbrachter Ventilatorbaugruppe;
- Figur 3: in perspektivischer Detailansicht einen unteren horizontalen Bereich des Trägers;
- Figur 4: in perspektivischer Ansicht einen Teil des Gehäuses des Kühlgerätes; und
- Figuren 5 bis 7: eine Bewegungssequenz, die das Verschwenken der Ventilatorbaugruppe aus der Montageposition in die Parkstellung veranschaulicht.

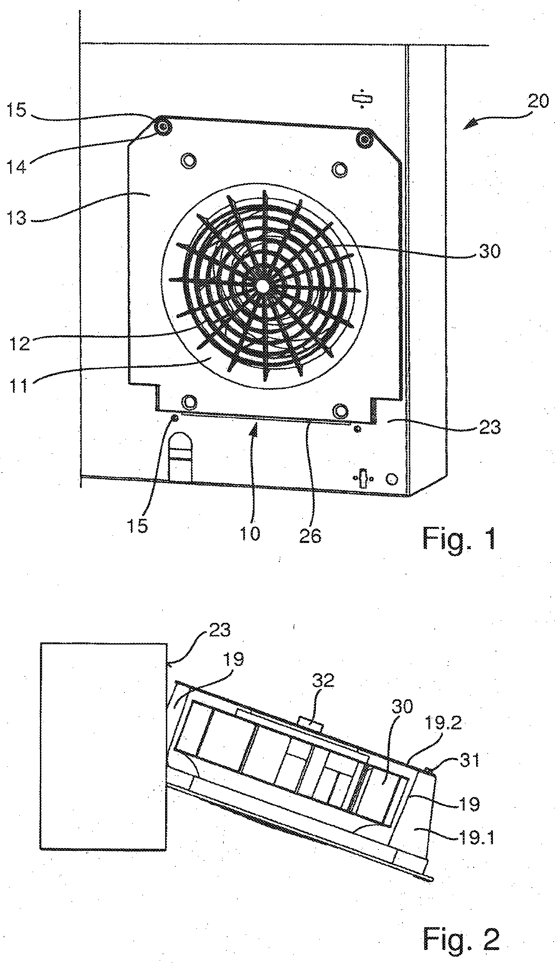

Figur 1 zeigt einen Abschnitt eines Kühlgerätes, das an einen Schaltschrank angebaut werden kann. Derartige Kühlgeräte lassen sich bspw. an die vertikalen Seitenwände oder auf das Dach eines Schaltschrankes aufbauen. Sie weisen üblicherweise einen oder zwei voneinander getrennte Kühlkreisläufe auf, denen jeweils ein Ventilator 30 zugeordnet ist. Der Ventilator 30 fördert Luft durch den Kühlkreislauf und ermöglicht so die Wärmeübertragung zwischen der transportierten Luft und einem dem Kühlkreislauf zugeordneten Wärmetauscher. Wie die Figur 1 veranschaulicht, weist das Gehäuse 20 des Kühlgerätes einen Wandung 23 auf, an der eine Ventilatorbaugruppe gehalten ist. Die Ventilatorbaugruppe umfasst einen Träger 10 und, wie dies die Figur 2 veranschaulicht, einen Ventilator 30. Der Träger 10 besitzt eine flächige Abdeckung 13, die mit einem umlaufenden Düsenansatz 11 einen Luftdurchtrittsbereich umschließt. Der Düsenansatz 11 ist dabei als konvex gewölbter Strömungsbereich ausgeführt, der einteilig mit dem Träger 10 verbunden ist. Wie Figur 1 deutlicher zeigt, ist an dem Düsenansatz 11 einteilig ein Lüftergitter 12 angeformt, das den Durchgriff auf einen dahinter angeordneten Ventilator 30 verhindert.

Figur 2 veranschaulicht die Befestigung des Ventilators 30 an dem Träger 10. Wie diese Darstellung erkennen lässt, sind an dem Träger 10 rückseitig Schraubdome 19 angeformt, die eine Befestigungsplatte 19.2 parallel beabstandet zu der Wandung 23 halten. Die Befestigungsplatte 19.2 ist mittels Befestigungsschrauben 31 mit den Schraubdomen 19 verbunden. Um die im Betriebseinsatz auftretenden Vibrationen des Trägers 10 sicher aufnehmen zu können, sind Versteifungsrippen 19.1 vorgesehen, die die Schraubdome 19 einteilig mit der Abdeckung 13 verbinden. Die Befestigungsplatte 19.2 trägt den Ventilator 30 und richtet ihn gegenüber dem Düsenansatz 11 aus.

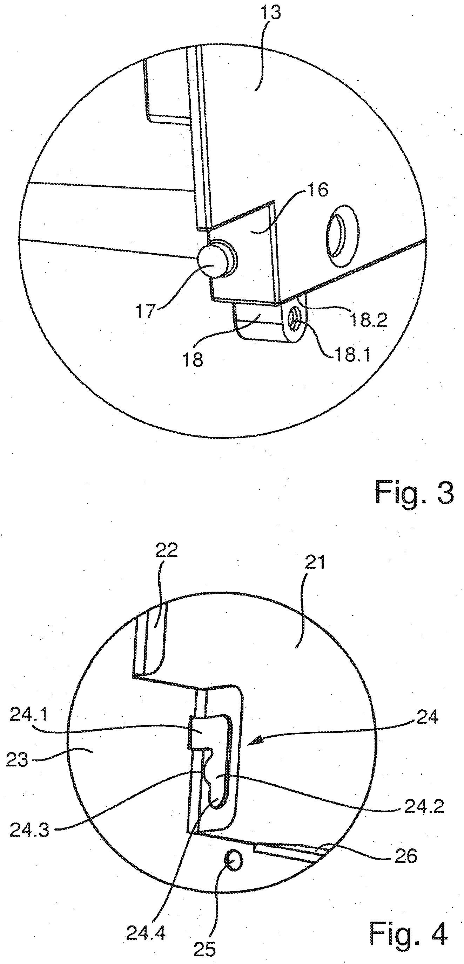

Figur 3 lässt den unteren horizontalen Randbereich des Trägers 10 als vergrößertes Detail näher erkennen. Wie diese Zeichnung veranschaulicht, weist der Träger 13 an seinen beiden vertikalen Rändern Seitenteile 16 auf, die an die Abdeckung 13 angeformt sind und rechtwinklig zu dieser nach hinten vorstehen. Die Seitenteile 16 sind mit angeformten Scharnierbolzen 17 ausgestattet. Dabei trägt jedes Seitenteil 16 einen Scharnierbolzen 17, deren Mittellängsachsen eine gemeinsame Scharnierachse bilden. Der Träger 10 weist weiterhin einen unteren horizontalen Rand 18.2 auf, der rechtwinklig an die Abdeckung 13 angeformt ist. Der untere horizontale Rand 18.2 trägt in den dem Scharnierbolzen 17 zugeordneten Eckbereichen jeweils einen Ansatz 18, der mit einer Schraubaufnahme 18.1 in Form einer Durchgangsbohrung ausgerüstet ist.

Figur 4 veranschaulicht näher die Gestaltung des Gehäuses 20 im Bereich der Öffnung 21. Wie diese Darstellung erkennen lässt, wird die Öffnung 21 seitlich von zwei vertikalen Rändern 22 begrenzt, die rechtwinklig von der Wandung 23 nach hinten abgekantet sind. In die Ränder 22 sind jeweils eine Scharnieraufnahme 24 eingearbeitet. Die Scharnieraufnahme 24 ist dabei langlochartig ausgebildet und weist einen Einführabschnitt 24.1 auf, der in eine vertikale Schiebeführung 24.2 des Langloches mündet. Die Schiebeführung 24.2 schließt mit einer unteren Parkaufnahme 24.4 ab. Im Bereich zwischen der Parkaufnahme 24.4 und dem Einführabschnitt 24.1 ist eine Schwenkaufnahme 24.3 in Form einer seitlichen Ausbuchtung in die Scharnieraufnahme eingebracht. Der untere horizontale Rand der Öffnung 21 ist mit einer horizontalen Abkantung 26 begrenzt. Diese erstreckt sich rechtwinklig zu der Wandung 23 und ist von dieser nach hinten abgekantet.

Nachfolgend wird die Vorgehensweise zur Montage der Ventilatorbaugruppe an dem Gehäuse 20 des Kühlgerätes beschrieben.

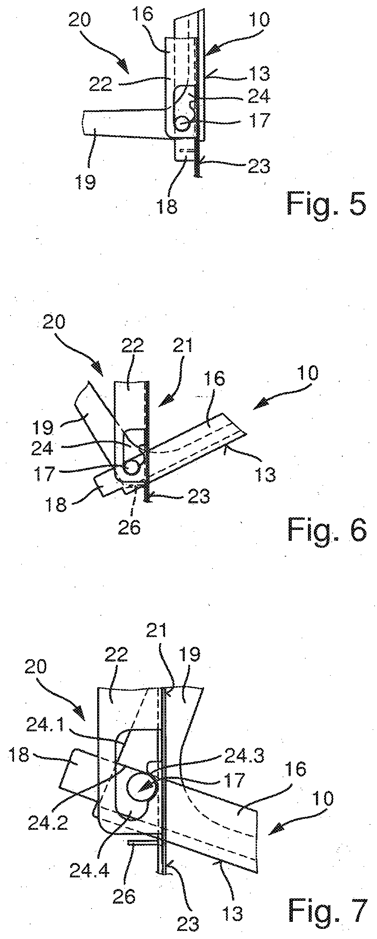

Zunächst wird die Ventilatorbaugruppe mit ihren beiden Scharnierbolzen 17 in die Einführabschnitte 24.1 der Scharnieraufnahme 24 eingeschoben. Dabei gelangen die Scharnierbolzen 17 in den Bereich der Schiebeführungen 24.2. Unterstützt durch die Schwerkraft der Ventilatorbaugruppe kann diese in der Schiebeführung 24.2 in Richtung vertikal nach unten abgesenkt werden. Dabei trifft die Abdeckung 13 des Trägers 10 auf die untere horizontale Abkantung 26 des Gehäuses. In dieser Position wird aufgrund der Gewichtskraft der Ventilatorbaugruppe ein Drehmoment erzeugt, das um die Schwenkachse dreht. Dabei wird der wirksame Hebelarm zwischen der Schwenkachse der Scharnierbolzen 17 und dem Abstand der Abstützstelle zwischen Abkantung 26 und Wandung 23 gebildet. Das Drehmoment hält die Scharnierbolzen 17 formschlüssig in der Schwenkaufnahme 24.3. Diese sichere Abstützung der Ventilatorbaugruppe ermöglicht es dem Monteur, die elektrische Verbindung 32 des Ventilators 30 an ein Kabel des Kühlgerätes anzuschließen. Anschließend kann die Ventilatorbaugruppe aus ihrer Parkstellung, die in den Figuren 2 und 7 veranschaulicht ist, nach oben geschwenkt werden, wobei die Schwenkbewegung um die durch die Scharnierverbindung entstehende Scharnierachse verläuft.

Figur 6 zeigt die Ventilatorbaugruppe in einer teilverschwenkten Stellung. Wie daraus ersichtlich wird, bewegen sich die Scharnierbolzen 17 beim Hochschwenken der Ventilatorbaugruppe aus der Schwenkaufnahme 24.3 heraus und gleiten in die Parkaufnahme 24.4. In dieser Parkaufnahme 24.4 kann die Schwenkbewegung fortgesetzt werden, bis die Ventilatorbaugruppe ihre vertikale Stellung und damit die Montageposition erreicht. Dabei liegen die Seitenteile 16 des Trägers 10 den Rändern 22 des Gehäuses 20 gegenüber. Die Ansätze 18 schlagen rückseitig an die Wandung 23 des Gehäuses 20 derart an, dass ihre Schraubaufnahmen 18.1 in Flucht zu Durchbrüchen der Wandung 23 stehen. Durch diese Durchbrüche können Befestigungsschrauben 15 (siehe Figur 1) hindurchgeführt und in die Schraubaufnahmen 18.1 eingeschraubt werden.

Am horizontalen oberen Rand des Trägers 10 sind, wie dies die Figur 1 weiter veranschaulicht, zwei weitere Befestigungsaufnahmen 14 vorgesehen. Durch diese können Befestigungsschrauben 15 hindurchgesteckt und in Gewindeaufnahmen des Gehäuses 20 eingeschraubt werden. Auf diese Weise wird die Ventilatorbaugruppe mit vier Befestigungsschrauben 15 zuverlässig fixiert. Diese Befestigungsart wird gewählt, wenn starke mechanische Beanspruchungen auf das Kühlgerät einwirken, wenn bspw. dynamische Wechsellasten wirken. Bei geringeren Ansprüchen an die Befestigungsart kann es ausreichen, dass lediglich die beiden oberen Befestigungsschrauben 15 vorgesehen sind, und dass die Ventilatorbaugruppe sich an ihrem unteren horizontalen Rand alleine mit den Scharnierbolzen 17 in der Scharnieraufnahme 24 hält.

Die Demontage der Ventilatorbaugruppe erfolgt zu der oben beschriebenen Montagereihenfolge in umgekehrter Richtung. Zunächst werden die vier Befestigungsschrauben 15 gelöst. Anschließend kann die Ventilatorbaugruppe aus ihrer Montageposition gemäß Figur 1 bzw. 5 abgeklappt werden (siehe Figur 6). Dabei trifft der Träger 10 mit seiner Abdeckung 13 auf die Abkantung 26. Dadurch entsteht ein Hebelarm und ein Drehmoment, der die Scharnierbolzen 17 aus der Parkaufnahme 24.4 heraushebt und in die Schwenkaufnahme 24.3 hineinbewegt. Dabei ist dann die sichere Festlegung der Ventilatorbaugruppe in der Parkstellung gemäß den Figuren 2 bzw. 7, wie oben erläutert, erreicht. Die Ventilatorbaugruppe lässt sich aus dieser Parkstellung heraus in der Schiebeführung 24.2 vertikal nach oben bewegen, bis die Scharnierbolzen 17 am oberen horizontalen Rand der Schiebeführung 24.2 anschlagen. Anschließend können die Scharnierbolzen 17 einfach über die Einführabschnitte 24.1 aus der Scharnieraufnahme 24 herausgezogen werden.

## Patentansprüche

1. Kühlgerät, insbesondere für einen Schaltschrank, mit einem Gehäuse (20), das eine Öffnung (21) aufweist, in die oder an der eine Ventilatorbaugruppe mit einem Träger (10), der eine flächige Abdeckung (13) umfasst, welche einen Luftdurchtrittsbereich aufweist, und einem dahinter angeordneten Ventilator (30) eingesetzt ist, wobei das Gehäuse (20) eine Öffnung (21) zur Aufnahme der Ventilatorbaugruppe aufweist, wobei der Träger (10) mit dem Gehäuse (20) lösbar verbunden ist, indem der Träger (10) mit dem Gehäuse (20) über eine Scharnieranordnung mit wenigstens einem Scharnierbolzen (17) und wenigstens einer Scharnieraufnahme (24) schwenkbar verbunden ist, so dass der Träger (10) zwischen einer Montageposition und einer Parkstellung verschwenkbar ist, wobei die Scharnieraufnahme (24) einen Einführabschnitt (24.1) aufweist, durch den der Scharnierbolzen (17) aus der oder in die Scharnieraufnahme (24) bewegbar ist, wobei der Scharnierbolzen (17) in der langlochartig ausgebildeten Scharnieraufnahme (24) verstellbar ist, deren eines Ende als Parkaufnahme (24.4) ausgebildet ist, und in der der Scharnierbolzen (17) in der Montagestellung des Trägers (10) gehalten ist,
**dadurch gekennzeichnet, dass** die Öffnung (21) des Gehäuses (20) mit einer horizontalen Abkantung (26) im Bereich des Scharnierbolzens (17) versehen ist, dass der Scharnierbolzen (17) in der abgeklappten Parkstellung des Trägers (10) in eine Schwenkaufnahme (24.3) in Form einer seitlichen Ausbuchung der Scharnieraufnahme (24) hinein verstellt und darin formschlüssig gehalten ist, wobei die Abdeckung (13) des Trägers (10) auf die Abkantung (26) des Gehäuses (20) trifft.

2. Kühlgerät nach Anspruch 1,
**dadurch gekennzeichnet,**
**dass** die Scharnieraufnahme (24) eine Schiebeführung (24.2) aufweist, in der der Scharnierbolzen (17) zwischen der der Montageposition zugeordneten Stellung und einer Demontagestellung verstellbar ist.

3. Kühlgerät nach Anspruch 1 oder 2,
**dadurch gekennzeichnet,**
**dass** das Gehäuse (20) eine Wandung (23) aufweist, die von zwei einander gegenüberliegenden Rändern (22) begrenzt ist,
**dass** die Ränder (22) von der Wandung (23) abgekantet sind und rückseitig über diese vorstehen, und
**dass** die Ränder (22) jeweils eine Scharnieraufnahme (24) oder einen Scharnierbolzen (17) aufweisen.

4. Kühlgerät nach einem der Ansprüche 1 bis 3,
**dadurch gekennzeichnet,**
**dass** der Träger (10) ein einteilig angeformtes Lüftungsgitter (12) aufweist.

5. Kühlgerät nach einem der Ansprüche 1 bis 4,
**dadurch gekennzeichnet,**
**dass** der Träger (10) einen Luftdurchtrittsquerschnitt aufweist, der von einem einteilig an dem Träger (10) angeformten Düsenansatz (11) begrenzt ist.

6. Kühlgerät nach einem der Ansprüche 1 bis 5,
**dadurch gekennzeichnet,**
**dass** der Träger (10) rückseitig vorstehende Schraubdome (19) aufweist, mit denen eine Trägerplatte (19.2) verbunden ist, und
**dass** die Trägerplatte (19.2) den Ventilator (30) auswechselbar aufnimmt.

7. Kühlgerät nach einem der Ansprüche 1 bis 6,
**dadurch gekennzeichnet,**
**dass** an die Abdeckung (13) mittelbar oder unmittelbar Seitenteile (16) angeformt sind, die rückseitig über die Abdeckung (13) vorstehen und im montierten Zustand des Trägers (10) durch die Öffnung (21) hindurchreichen, und dass die Seitenteile (16) die Scharnierbolzen (17) oder die Scharnieraufnahmen (24) tragen.

8. Kühlgerät nach einem der Ansprüche 1 bis 7,
**dadurch gekennzeichnet,**
**dass** die Schwenkachse der Schwenklagerung im Bereich der Rückseite der Abdeckung (13) des Trägers (10) verläuft.

9. Kühlgerät nach einem der Ansprüche 1 bis 8,
**dadurch gekennzeichnet,**
**dass** der Träger (10) an gegenüberliegenden Seiten an dem Gehäuse (20) verschraubbar ist, wobei er sich an einer Seite vorderseitig an einer Wandung (23) des Gehäuses (20) und an der anderen Seite rückseitig an dieser abstützt.

## Claims

1. A cooling device, in particular for a control cabinet, having a housing (20) which comprises an opening (21) into which or on which a fan assembly having a support (10) comprising a plane cover (13) with an air passage area, and a fan (30) located behind it is inserted, wherein the housing (20) comprises an opening (21) for receiving the fan assembly, wherein the support is detachably connected to the housing (20) by means of a hinge assembly having at least one hinge pin (17) and at least one hinge receptacle (24) so that the support (10) can be pivoted between an installation position and a parking position, wherein the hinge receptacle (24) comprises an insertion section (24.1) through which the hinge pin (17) can be moved into or out of the hinge receptacle (24), wherein the hinge pin (17) is displaceable within the elongated hole-like hinge receptacle (24), the first end of which is formed as a parking receptacle (24.4) in which the hinge pin (17) is held in the installation position of the support (10),
**characterized in that** the opening (21) of the housing (20) is provided with a horizontal chamfer (26) in the area of the hinge pin (17), wherein in the hinged down parking position of the support, the hinge pin (17) is displaced into a pivoted receptacle (24.3) formed as a lateral bulge and is form-fittingly held therein, in which the cover (13) of the support (10) meets the chamfer (26) of the housing (20).

2. The cooling device of claim 1, wherein the hinge receptacle (24) comprises a slide guide (24.2) in which the hinge pin (17) can be displaced between a position associated with the installation position and a de-installation position.

3. The cooling device of claim 1 or 2, wherein the housing (20) comprises a wall (23) delimited by two opposite rims (22), the rims (22) are bent from the wall (23) and extend therefrom on the back side, and the rims (22) respectively comprise either a hinge receptacle (24) or a hinge pin (17).

4. The cooling device according to one of claims 1 to 3, wherein the support (10) comprises a ventilation grille (12) integrally molded thereto.

5. The cooling device according to one of claims 1 to 4, wherein the support (10) comprises an air outlet cross section which is delimited by a nozzle flange (11) integrally molded to the support (10).

6. The cooling device according to one of claims 1 to 7, wherein the support (10) comprises screw domes (19) protruding from its rear side by which a support plate (19.2) is connected and the support plate (19.2) receives the fan (30) exchangeably.

7. The cooling device according to one of claims 1 to 6, wherein side parts (16) are directly or indirectly molded to the cover (17) which extend beyond the cover (17) on its back side and which protrude through the opening (21) in an installed state of the support (10), and the side parts (16) carry the hinge pins (17)or the hinge receptacles (24).

8. The cooling device according to one of claims 1 to 7, wherein the pivot axis of the pivot linkage extends in the region of the back side of the cover (13) of the support (10).

9. The cooling device according to one of claims 1 to 8, wherein the support (10) can be screw-fastened on opposite sides to the housing (20) while resting at a front side of a wall (23) of the housing (20) with one side and resting at a back side with the other side.

## Revendications

1. Appareil de refroidissement pour une armoire de commande, avec un boîtier (20), qui comprend une ouverture (21), dans laquelle ou au niveau de laquelle un sous-ensemble de ventilateur avec un support (10), qui comprend une protection plate (13), qui comprend une zone de passage d'air, et un ventilateur (30) disposé derrière est inséré, le boîtier (20) comprenant une ouverture (21) pour le logement du sous-ensemble de ventilateur, le support (10) étant relié de manière mobile avec le boîtier (20), grâce au fait que le support (10) est relié de manière pivotante avec le boîtier (20) par l'intermédiaire d'un dispositif à charnière avec au moins un axe de charnière (17) et au moins un logement de charnière (24), de façon à ce que le support (10) puisse être pivoté entre une position de montage et une position de rangement, le logement de charnière (24) comprenant une portion d'introduction (24.1), à travers laquelle l'axe de charnière (17) peut être réglé dans le logement de charnière (24) conçu sous la forme d'un trou oblong, dont une extrémité est conçue comme un logement de rangement (24.4) et dans laquelle l'axe de charnière (17) est maintenu en position de montage du support (10),
**caractérisé en ce que** l'ouverture (21) du boîtier (20) est munie d'un repli horizontal (26) au niveau de l'axe de charnière (17), **en ce que** l'axe de charnière (17) se déplace, dans la position de rangement du support (10), dans un logement de charnière (24.3) sous la forme d'un renflement latéral du logement de charnière (24) et y est maintenu par complémentarité de forme, la protection (13) du support (10) atteignant le repli (26) du boîtier (20).

2. Appareil de refroidissement selon la revendication 1, **caractérisé en ce que** le logement de charnière (24) comprend un guidage coulissant (24.2) dans lequel l'axe de charnière (17) peut être déplacé entre la position correspondant à la position de montage et une position de démontage.

3. Appareil de refroidissement selon la revendication 1 ou 2, **caractérisé en ce que** le boîtier (20) comprend une paroi (23) qui est limitée par deux bords (22) opposés, **en ce que** les bords (22) sont repliés par la paroi (23) et dépassent de celle-ci à l'arrière et **en ce que** les bords (22) comprennent chacun un logement de charnière (24) ou un axe de charnière (17).

4. Appareil de refroidissement selon l'une des revendications 1 à 3, **caractérisé en ce que** le support (10) comprend une grille de ventilation (12) formée d'une seule pièce.

5. Appareil de refroidissement selon l'une des revendications 1 à 4, **caractérisé en ce que** le support (10) présente une section transversale de passage d'air qui est limitée par un embout à buse (11) formé d'une seule pièce sur le support (10).

6. Appareil de refroidissement selon l'une des revendications 1 à 5, **caractérisé en ce que** le support (10) comprend des dômes de vissage (19) dépassant à l'arrière, avec lesquelles la plaque de support (19.2) est reliée, et **en ce que** la plaque de support (19.2) du ventilateur (30) est interchangeable.

7. Appareil de refroidissement selon l'une des revendications 1 à 6, **caractérisé en ce que**, sur la protection (13) sont formées, indirectement ou directement, des parties latérales (16) qui dépassent à l'arrière de la protection (13) et traversent l'ouverture (21) lorsque le support (10) est monté et **en ce que** les parties latérales (16) supportent les axes de charnière (17) ou les logements de charnière (24).

8. Appareil de refroidissement selon l'une des revendications 1 à 7, **caractérisé en ce que** l'axe de pivotement du logement pivotant s'étend à l'arrière de la protection (13) du support (10).

9. Appareil de refroidissement selon l'une des revendications 1 à 8, **caractérisé en ce que** le support (10) peut être vissé sur des côtés opposés sur le boîtier (20), moyennant quoi il s'appuie, au niveau d'un côté, à l'avant, contre une paroi (23) du boîtier (20) et contre celle-ci à l'arrière de l'autre côté.
